(19) **Europäisches Patentamt / European Patent Office / Office européen des brevets**

(11) **EP 2 930 759 B1**

(12) # FASCICULE DE BREVET EUROPEEN

(45) Date de publication et mention de la délivrance du brevet:
**06.06.2018 Bulletin 2018/23**

(21) Numéro de dépôt: **15305539.7**

(22) Date de dépôt: **10.04.2015**

(51) Int Cl.:
*H01L 35/16* $^{(2006.01)}$   *C01G 19/00* $^{(2006.01)}$

(54) **MATÉRIAU THERMOÉLECTRIQUE ET PROCÉDÉ DE FABRICATION**

Thermoelektrisches Material und Verfahren zur Herstellung

Thermoelectric material and method of fabrication

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **11.04.2014 FR 1453253**

(43) Date de publication de la demande:
**14.10.2015 Bulletin 2015/42**

(73) Titulaire: **IMRA Europe SAS**
**06560 Valbonne (FR)**

(72) Inventeurs:
• **Jacob, Stéphane**
  **06160 JUAN LES PINS (FR)**
• **Chmielowski, Radoslaw Stanislaw**
  **06250 MOUGINS (FR)**
• **Dennler, Gilles**
  **06550 LA ROQUETTE SUR SIAGNE (FR)**
• **Opahle, Ingo**
  **64743 BEERFELDEN (DE)**
• **Bera, Chandan**
  **Mohali-160062**
  **Punjab (IN)**
• **Madsen, Georg Kent Hellerup**
  **58455 WITTEN (DE)**

(74) Mandataire: **Lefevre-Groboillot, David André**
**Cabinet Weinstein**
**176 avenue Charles de Gaulle**
**92200 Neuilly sur Seine (FR)**

(56) Documents cités:
**WO-A1-2010/080153**

• **CHANDAN BERA ET AL: "Integrated computational materials discovery of silver doped tin sulfide as a thermoelectric material", PHYSICAL CHEMISTRY CHEMICAL PHYSICS, vol. 16, no. 37, 23 juillet 2014 (2014-07-23), page 19894, XP055155645, ISSN: 1463-9076, DOI: 10.1039/C4CP02871F**
• **DAVID PARKER ET AL: "First principles investigations of the thermoelectric behavior of tin sulfide", JOURNAL OF APPLIED PHYSICS, vol. 108, no. 8, 1 janvier 2010 (2010-01-01), page 083712, XP055155306, ISSN: 0021-8979, DOI: 10.1063/1.3496661**
• **M. DEVIKA ET AL: "Low Resistive Micrometer-Thick SnS:Ag Films for Optoelectronic Applications", JOURNAL OF THE ELECTROCHEMICAL SOCIETY, vol. 153, no. 8, 1 janvier 2006 (2006-01-01), page G727, XP055191116, ISSN: 0013-4651, DOI: 10.1149/1.2204870**
• **PE MIN LU ET AL: "Optical and Electrical Properties of SnS: Ag Films as Solar Cell Absorbers", ADVANCED MATERIALS RESEARCH, vol. 60-61, 1 janvier 2009 (2009-01-01), pages 11-15, XP055191183, ISSN: 1022-6680, DOI: 10.4028/www.scientific.net/AMR.60-61.11**
• **ZHANG SHUAI ET AL: "Thermally evaporated SnS:Cu thin films for solar cells", MICRO AND NANO LETTERS, THE INSTITUTION OF ENGINEERING AND TECHNOLOGY, MICHAEL FARADAY HOUSE, SIX HILLS WAY, STEVENAGE, HERTS. SG1 2AY, UK, vol. 6, no. 7, 31 juillet 2011 (2011-07-31), pages 559-562, XP006043299, DOI: 10.1049/MNL.2011.0121**

EP 2 930 759 B1

- ARTIT WANGPERAWONG ET AL: "Vapor transport deposition and epitaxy of orthorhombic SnS on glass and NaCl substrates", APPLIED PHYSICS LETTERS, vol. 103, no. 5, 1 janvier 2013 (2013-01-01), page 052105, XP055155307, ISSN: 0003-6951, DOI: 10.1063/1.4816746
- NOGUCHI H ET AL: "CHARACTERIZATION OF VACUUM-EVAPORATED TIN SULFIDE FILM FOR SOLAR CELL MATERIALS", SOLAR ENERGY MATERIALS AND SOLAR CELLS, ELSEVIER SCIENCE PUBLISHERS, AMSTERDAM, NL, vol. 35, no. 1/04, 1 septembre 1994 (1994-09-01), pages 325-331, XP000737084, ISSN: 0927-0248, DOI: 10.1016/0927-0248(94)90158-9
- LI-DONG ZHAO ET AL: "Thermoelectrics with Earth Abundant Elements: High Performance p-type PbS Nanostructured with SrS and CaS", JOURNAL OF THE AMERICAN CHEMICAL SOCIETY, vol. 134, no. 18, 9 mai 2012 (2012-05-09), pages 7902-7912, XP055155664, ISSN: 0002-7863, DOI: 10.1021/ja301772w
- NASSARY ET AL: "Temperature dependence of the electrical conductivity, Hall effect and thermoelectric power of SnS single crystals", JOURNAL OF ALLOYS AND COMPOUNDS, ELSEVIER SEQUOIA, LAUSANNE, CH, vol. 398, no. 1-2, 2 août 2005 (2005-08-02), pages 21-25, XP027812683, ISSN: 0925-8388 [extrait le 2005-08-02]

**Description**

L'invention concerne un matériau thermoélectrique ainsi qu'un procédé de fabrication de ce matériau.

L'effet thermoélectrique est un phénomène physique présent dans certains matériaux qui lie le flux de chaleur qui les traverse à la puissance électrique qui les parcourt.

Les matériaux thermoélectriques ont ainsi la double capacité de générer une puissance électrique lorsqu'ils sont exposés à un gradient de température (effet Seebeck), et de générer un flux de chaleur lorsqu'un courant électrique leur est appliqué dans la masse (effet Peltier).

Les performances des matériaux thermoélectriques dépendent de la gamme de température dans lesquelles ils sont utilisés.

Pour une plage de température dite moyenne de 0 à 300 °C environ, les matériaux thermoélectriques les plus efficaces connus sont composés de tellure de bismuth de formule $Bi_xTe_y$, ou de sulfure de plomb de formule $Pb_wS_z$.

Mais ces matériaux présentent des inconvénients propres à leur composition. La dangerosité du plomb est une question non résolue à ce jour et le tellure est un matériau rare dont le prix élevé est soumis à d'importantes fluctuations.

DAVID PARKER ET AL: "First principles investigations of the thermoelectric behavior of tin sulfide", JOURNAL OF APPLIED PHYSICS, vol. 108, no. 8, 1 janvier 2010 (2010-01-01), page 083712, XP055155306, ISSN: 0021-8979, DOI: 10.1063/1.3496661 présente des calculs relatifs à du SnS dopé. M. DEVIKA ET AL: "Low Resistive Micrometer-Thick SnS:Ag Films for Optoelectronic Applications", JOURNAL OF THE ELECTROCHEMICAL SOCIETY, vol. 153, no. 8, 1 janvier 2006 (2006-01-01), page G727, XP055191116, ISSN: 0013-4651, DOI: 10.1149/1.2204870 divulgue des films minces à propriétés optoélectroniques. ARTIT WANGPERAWONG ET AL: "Vapor transport déposition and epitaxy of orthorhombic SnS on glass and NaCl substrates", APPLIED PHYSICS LETTERS, vol. 103, no. 5, 1 janvier 2013 (2013-01-01), page 052105, XP055155307, ISSN: 0003-6951, DOI: 10.1063/1.4816746 divulgue un matériau thermoélectrique composé de sulfure d'étain. NASSARY ET AL: "Temperature dependence of the electrical conductivity, Hall effect and thermoelectric power of SnS single crystals", JOURNAL OF ALLOYS AND COMPOUNDS, ELSEVIER SEQUOIA, LAUSANNE, CH, vol. 398, no. 1-2, 2 août 2005 (2005-08-02), pages 21-25, XP027812683, ISSN: 0925-8388 divulgue également un matériau thermoélectrique composé de sulfure d'étain.

Dans ce contexte, la présente invention vise un matériau thermoélectrique non toxique ou composé d'éléments non toxiques, de faible coût, et suffisamment efficace pour la gamme de température moyenne précitée.

A cet effet, le matériau thermoélectrique de l'invention est essentiellement caractérisé en ce qu'il est composé de sulfure d'étain incluant la présence d'au moins un dopant produisant un déficit d'électrons, ce qui conduit à réaliser un sulfure d'étain dopé de type p, lequel matériau thermoélectrique présente un facteur de puissance supérieur à 150 $\mu$W K$^{-2}$ m$^{-1}$. Le matériau thermoélectrique de l'invention peut également comporter les caractéristiques optionnelles suivantes considérées isolément ou selon toutes les combinaisons techniques possibles :

-    le dopant est un élément présentant un nombre d'oxydation maximum de +1.

  -    le sulfure d'étain est dopé avec de l'argent.
  -    le pourcentage atomique de l'argent dans le sulfure d'étain est compris entre 0,02 et 5.
  -    le pourcentage atomique de l'argent dans le sulfure d'étain est compris entre 0,2 et 3,25.
  -    le sulfure d'étain est dopé avec du cuivre.
  -    le pourcentage atomique de cuivre dans le sulfure d'étain est compris entre 1 et 3.
  -    le pourcentage atomique de cuivre dans le sulfure d'étain est compris entre 2 et 2,5.
  -    le sulfure d'étain est en outre dopé avec du soufre.
  -    le sulfure d'étain est dopé avec de l'argent et du soufre.
  -    le pourcentage atomique d'argent dans le sulfure d'étain est supérieur à 0,5, et le pourcentage atomique de soufre dans le sulfure d'étain est inférieur à 5.
  -    le pourcentage atomique d'argent dans le sulfure d'étain est d'environ 2.
  -    le sulfure d'étain est dopé avec du cuivre et du soufre
  -    le sulfure d'étain est dopé avec un chalcogénure métallique dont le nombre d'oxydation maximum du métal est de +1.

-    le sulfure d'étain est dopé avec du sulfure d'argent, du sulfure de cuivre ou du sulfure de lithium.
-    le pourcentage molaire de sulfure d'argent dans le sulfure d'étain est compris entre 0,25 et 1.

L'invention porte également sur un procédé de fabrication du matériau semi-conducteur énoncé précédemment qui est essentiellement caractérisé en ce qu'il comprend au moins une étape de compactage par frittage d'un mélange broyé de poudres de sulfure d'étain avec au moins un élément dopant.

Avantageusement, le mélange broyé de poudres est placé dans un moule et est soumis :

- à une augmentation de température par passage d'un courant dans les poudres au moyen de l'action des deux pistons de compactage en appui de contact sur le moule et qui sont reliés à une alimentation électrique, et
- à une étape de compactage.

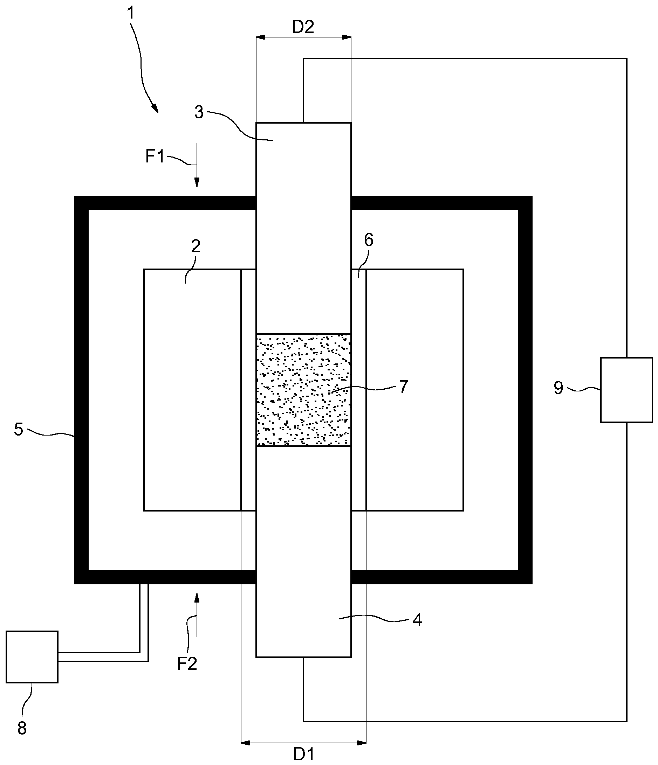

D'autres caractéristiques et avantages de l'invention ressortiront clairement de la description qui en est donnée ci-dessous, à titre indicatif et nullement limitatif, en référence à la figure unique annexée qui représente schématiquement l'installation de frittage pour fabriquer le matériau thermoélectrique de l'invention.

Dans la description qui suit, la référence au pourcentage atomique d'argent, cuivre, soufre et autres dopants simples (élément simple), s'entend par le pourcentage d'atome de ce dopant par rapport à l'ensemble des atomes de métaux présents dans le matériau final dopé.

Egalement, la référence au pourcentage molaire de sulfure d'argent, sulfure de cuivre ou sulfure de lithium, s'entend par le pourcentage de mole de ces dits sulfures sur la somme des moles de SnS et de dopants sulfure présents dans le matériau final dopé.

Selon l'invention, un matériau à fort potentiel thermoélectrique est obtenu à partir du sulfure d'étain dopé de type p, c'est-à-dire du sulfure d'étain qui inclut la présence d'au moins un dopant produisant un déficit d'électrons.

Le dopage est réalisé avec un ou plusieurs éléments qui présentent un nombre d'oxydation maximum de +1.

Le ou les éléments dopant peuvent être un métal ou un chalcogénure métallique dont le métal présente un nombre d'oxydation maximum de +1.

Dans le cadre de l'invention, le potentiel thermoélectrique peut être encore augmenté par ajout de soufre. Cet ajout peut être fait en plus de l'élément métallique dopant, ou être intégré à l'élément dopant.

Un matériau thermoélectrique est caractérisé par sa figure de mérite ZT qui s'exprime de la façon suivante :

$$ZT = \frac{S^2 \sigma T}{\kappa} \qquad (1)$$

Où S est le coefficient de Seebeck ($\mu$V.K$^{-1}$)
$\sigma$ est la conductivité électrique (S.m$^{-1}$)
k est la conductivité thermique (W.K$^{-1}$.m$^{-1}$)
T la température (K)

La figure de mérite ZT peut également s'exprimer de la façon suivante :

$$ZT = \frac{S^2 T}{\rho \kappa} \qquad (2)$$

Où $\rho$ est la résistivité électrique (en $\Omega$.m)

Le facteur de mérite ZT a été conçu pour comparer les performances des matériaux thermoélectriques utilisés dans le mode Peltier. Dans le cas de l'utilisation de matériaux thermoélectriques dans le mode Seebeck, c'est-à-dire pour la génération de puissance électrique à partir d'un gradient de température, les performances des matériaux électriques peuvent être illustrées par un facteur de puissance PF qui s'exprime de la façon suivante :

$$PF = S^2 \cdot \sigma = S^2 \cdot \rho^{-1} \qquad (3)$$

Dans les exemples ci-dessous, les performances des matériaux thermoélectriques de l'invention sont ainsi caractérisées par leur facteur de puissance PF.

Les échantillons de sulfure d'étain dopé de type p sont préparés par la méthode de frittage également dénommé par le terme anglophone « Spark Plasma Sintering (SPS) ».

En référence à la figure unique, un mélange de sulfure d'étain et du ou des éléments dopants est préparé selon le taux de dopage souhaité.

Le mélange de poudres est ensuite broyé puis introduit dans un moule cylindrique 2 du dispositif de frittage 1. Le moule cylindrique 2 contenant la poudre 7 est ensuite disposé entre deux poinçons 3,4 qui se font face de part et d'autre du moule 2 dans une enceinte 5.

Le diamètre D1 du moule est de 7,5, 10,5 ou 15,5 millimètres tandis que les diamètres respectifs D2 des deux poinçons 3,4 sont de 7, 10 ou 15 millimètres. Ces 3 diamètres D1 et 3 diamètres D2 sont donnés à titre d'exemple, d'autres diamètres étant possibles.

La différence de 0,5 millimètres entre le diamètre D1 du moule 2 et les diamètres D2 des poinçons 3,4 permet d'interposer une feuille de graphite 6 entre le moule 2 d'une part et les poinçons 3,4 et la poudre 7 d'autre part pour protéger le moule 2 dans le cas où la poudre 7 réagirait avec le moule 2. Cependant, il est possible aussi de préparer les échantillons sans cette feuille de graphite. Dans le cas où elle n'est pas utilisée, le diamètre D1 du moule 2 est le même que le diamètre D2 des poinçons 3,4.

Une fine couche de nitrure de bore non représentée est également ajoutée sur la face extrémale des poinçons 3,4 en contact avec la poudre 7 pour éviter que la poudre 7 ne s'agglutine sur les poinçons 3,4 lors de l'opération de compactage.

Le vide est réalisé dans l'enceinte 5 au moyen d'un dispositif de mise sous vide 8 jusqu'à l'obtention d'une pression de $10^{-2}$ Pascal.

Avant le début du compactage, les deux poinçons sont soumis à une pression de 50 MPa en direction du moule 2 selon les flèches F1 et F2. La poudre 7 est alors chauffée par passage d'un courant continu pulsé réalisé au moyen d'une alimentation électrique 9 reliée aux deux poinçons 3,4. Le moule 2 et la poudre 7 sont ainsi chauffés de façon homogène par effet Joule.

La poudre 7 est chauffée jusqu'à 550 °C à une vitesse de chauffage de 100 °C/minutes jusqu'à 500 °C, puis à une vitesse de 50 °C/minute entre 500 et 550 °C. La température est maintenue à 550 °C pendant 2 minutes, puis la génération du courant est arrêtée pour permettre aux poudres 7 de refroidir lentement jusqu'à température ambiante. Ce procédé de chauffage est aussi donné à titre d'exemple. D'autres vitesses, temps de chauffage, pressions mécaniques et pressions de vide peuvent être choisis.

La surface de l'échantillon est polie avant d'effectuer les mesures de caractérisation sur les échantillons de sulfure d'étain dopé de type p.

Dans les exemples ci-dessous, une cartographie du coefficient de Seebeck S est obtenue par un dispositif de microsonde de potentiel Seebeck communément connu sous le terme anglophone « Potential-Seebeck Microprobe » ou PSM. La valeur moyenne du coefficient de Seebeck est obtenue par le programme associé à ce dispositif.

La résistivité $\rho$ des échantillons est mesurée par la méthode quatre pointes classiquement utilisée pour mesurer la résistivité d'un échantillon.

Le facteur de puissance PF est alors calculé selon la formule (3) et à partir des valeurs du coefficient de Seebeck S et de la résistivité $\rho$ précédemment obtenus.

On cherche à réaliser des matériaux thermoélectriques à base de sulfure d'étain aptes à concurrencer les matériaux thermoélectriques à base de tellure de bismuth en considérant de façon combinée le facteur de puissance PF et le coût de fabrication.

Dans ce sens, on considère qu'un facteur de puissance PF de 150 $\mu W\,K^{-2}\,m^{-1}$ permet de réaliser des matériaux thermoélectriques exploitables, et qu'un facteur de puissance de 300 $\mu W\,K^{-2}\,m^{-1}$ permet raisonnablement de réaliser des matériaux thermoélectriques aptes à concurrencer les matériaux thermoélectriques à base de de tellure de bismuth, puisque le facteur de puissance PF des matériaux thermoélectriques à base de tellure de bismuth est de l'ordre de 3000 pour un coût 10 fois plus élevé qu'un matériau thermoélectrique à base de sulfure d'étain dopé.

Les exemples ci-dessous non limitatifs exposent les performances thermoélectriques du sulfure d'étain respectivement dopé à l'argent, au cuivre, à l'argent et au soufre, au sulfure d'argent, au cuivre et au soufre, au sulfure de cuivre et sulfure de lithium.

Exemple 1 : Sulfure d'étain dopé à l'argent

Les résultats des performances thermoélectriques du sulfure d'étain dopé à l'argent sont présentés dans le Tableau 1 ci-dessous.

La résistivité et la moyenne du coefficient de Seebeck sont mesurées pour des échantillons dans lesquels le pourcentage atomique d'argent dans le sulfure d'étain varie jusqu'à 4%.

On constate une diminution importante de la résistivité au-delà de 0,025% d'argent pour des coefficients de Seebeck restés élevés. On notera que pour des teneurs en argent de 0,01 et 0,025, la résistivité est trop élevée pour mesurer les coefficients de Seebeck correspondants.

Il en résulte un facteur de puissance supérieur à 150 $\mu W\,K^{-2}$ pour des teneurs en argent de 0,05 et 4%, et un facteur de puissance supérieur à 300 $\mu W\,K^{-2}$ pour des teneurs en argent de 0,25, 0,5 et 2%.

On estime qu'un facteur de puissance égal ou supérieur à 300 $\mu W\,K^{-2}\,m^{-1}$ sera obtenu pour des teneurs en argent comprises entre 0,2 et 3,25%.

Tableau 1

| Teneur en Ag (% atomique) | Moyenne du coefficient de Seebeck ($\mu$V/K) | Résistivité moyenne ($\Omega$ cm) | Conductivité moyenne (S/cm) | Facteur de puissance ($\mu$W K$^{-2}$ m$^{-1}$ ) |
|---|---|---|---|---|
| 0 | - | 330 | 3,03 $10^{-3}$ | - |
| 0,01 | - | 89,5 | 1,12 $10^{-2}$ | - |
| 0,025 | - | 1,49 | 0,671 | - |
| 0,05 | 728 | 0,266 | 3,76 | 199 |
| 0,25 | 674 | 0,127 | 7,87 | 357 |
| 0,5 | 624 | 0,115 | 8,70 | 339 |
| 2 | 681 | 0,117 | 8,53 | 396 |
| 4 | 579 | 0,153 | 6,54 | 219 |

Exemple 2 : Sulfure d'étain dopé au cuivre

Les résultats des performances thermoélectriques du sulfure d'étain dopé au cuivre sont présentés dans le Tableau 2 ci-dessous pour des pourcentages atomiques en cuivre variant entre 0,25 et 10.

Pour des teneurs en cuivre de 0,25 et 0,5, les fortes valeurs de résistivité rendent impossible la mesure du coefficient de Seebeck. On constate en revanche à partir d'une teneur en cuivre de 2,2% une résistivité fortement diminuée.

Pour une teneur en cuivre de 2,2%, le facteur de puissance est de 325 $\mu$W K$^{-2}$ m$^{-1}$.

On estime qu'un facteur de puissance supérieur à 150 $\mu$W K$^{-2}$ m$^{-1}$ est obtenu pour des teneurs en cuivre comprises entre 1 et 3% et qu'un facteur de puissance supérieur supérieure à 300 $\mu$W K$^{-2}$ m$^{-1}$ est obtenu pour des teneurs en cuivre comprises entre 2 et 2,5%.

Tableau 2

| Teneur en Cu (% atomique) | Moyenne du coefficient de Seebeck ($\mu$V/K) | Résistivité moyenne ($\Omega$ cm) | Conductivité moyenne (S/cm) | Facteur de puissance ($\mu$W K$^{-2}$ m$^{-1}$ ) |
|---|---|---|---|---|
| 0 | - | 330 | 3,03 $10^{-3}$ | - |
| 0,25 | - | 13 | 1,12 $10^{-2}$ | - |
| 0,5 | - | 63,7 | 0,671 | - |
| 2,2 | 1145 | 0,404 | 2,48 | 325 |
| 5 | 1010 | 0,901 | 1,11 | 113 |
| 10 | 783 | 0,885 | 1,13 | 69,3 |

Exemple 3 : Sulfure d'étain dopé à l'argent et au soufre

Les résultats des performances thermoélectriques du sulfure d'étain dopé à l'argent et au soufre sont présentés dans le Tableau 3 ci-dessous.

Les échantillons de sulfure d'étain sont préparés avec un excès de soufre en ajoutant au mélange de poudres 7 (figure unique) contenant du sulfure d'étain et de l'argent, de la poudre de soufre.

On fait varier la teneur en argent de 0,25 à 4 et la teneur en soufre de 1 à 4,5 selon les échantillons.

Pour une teneur en argent de 0,25%, l'ajout de soufre ne modifie pas substantiellement la résistivité.

A l'inverse, pour des teneurs en argent égales ou supérieures à 0,5%, l'ajout de soufre conduit à une diminution générale de la résistivité.

On constate que c'est particulièrement le cas pour une teneur en argent de 2% et une teneur en soufre de 1%.

En revanche, une teneur en soufre trop importante, telle que 4,5%, produit l'effet inverse à savoir une augmentation importante de la résistivité et un facteur de puissance qui diminue en conséquence.

Tableau 3

| Teneur en Ag (% atomique) | Teneur en S (% atomique) | Moyenne du coefficient de Seebeck ($\mu$V/K) | Résistivité moyenne (m$\Omega$ cm) | Conductivité moyenne (S/cm) | Facteur de puissance ($\mu$W K$^{-2}$ m$^{-1}$) |
|---|---|---|---|---|---|
| 0,25 | 0 | 674 | 127 | 7,87 | 357 |
| 0,25 | 1 | 659 | 136 | 7,35 | 319 |
| 0,25 | 2 | 646 | 179 | 5,59 | 233 |
| 0,5 | 0 | 624 | 115 | 8,70 | 339 |
| 0,5 | 1 | 628 | 105 | 9,52 | 375 |
| 0,5 | 4,5 | 691 | 309 | 3,24 | 155 |
| 2 | 0 | 681 | 117 | 8,53 | 396 |
| 2 | 1 | 452 | 45 | 22,2 | 454 |
| 2 | 2 | 651 | 93,8 | 10,7 | 452 |
| 4 | 0 | 579 | 153 | 6,54 | 219 |
| 4 | 1 | 668 | 144 | 6,94 | 310 |
| 4 | 2 | 529 | 82,6 | 12,1 | 339 |

Exemple 4 : Sulfure d'étain dopé au sulfure d'argent

Dans cet exemple, l'excès de soufre est réalisé par l'ajout de sulfure d'argent.
Les résultats des performances thermoélectriques du sulfure d'étain dopé au sulfure d'argent sont présentés dans le Tableau 4 ci-dessous.
Les échantillons présentent une teneur en sulfure d'argent comprise entre 0,25 et 2%.
Le passage d'une teneur en sulfure d'argent de 0% à 0,25% s'accompagne d'une diminution drastique de la résistivité. Le facteur de Seebeck correspondant étant important, il en résulte ainsi que le facteur de puissance PF est de 442 $\mu$W K$^{-2}$ m$^{-1}$ pour une teneur en sulfure d'argent de 0,25%.
A une teneur en sulfure d'argent de 0,5 %, la résistivité continue de diminuer pour un facteur de Seebeck qui augmente, ce dont il résulte un facteur de puissance maximum de 572 $\mu$W K$^{-2}$ m$^{-1}$.
L'augmentation ultérieure de la teneur en sulfure d'argent à 1 et 2% conduit à une augmentation progressive de la résistivité avec un facteur de puissance qui décroit également. Les facteurs de puissance résultants passent alors respectivement à 450 et 286 $\mu$W K$^{-2}$ m$^{-1}$.

Tableau 4

| Teneur en Ag$_2$S (% molaire) | Moyenne du coefficient de Seebeck ($\mu$V/K) | Résistivité moyenne (m$\Omega$ cm) | Conductivité moyenne (S/cm) | Facteur de puissance ($\mu$W K$^{-2}$ m$^{-1}$) |
|---|---|---|---|---|
| 0 | - | 3,30 10$^5$ | 3,03 10$^{-3}$ | - |
| 0,25 | 671 | 102 | 9,84 | 442 |
| 0,5 | 682 | 81,3 | 12,3 | 572 |
| 1 | 643 | 91,9 | 10,9 | 450 |
| 2 | 612 | 131 | 7, 64 | 286 |

Ainsi, l'ajout d'un excès de soufre, que ce soit de façon dissociée à l'élément métallique dopant, ou intégré dans l'élément dopant, permet d'obtenir des facteurs de puissance bien supérieurs à ceux obtenus pour l'argent ou le cuivre seul.

Exemple 5 : Sulfure d'étain dopé au cuivre et au soufre

Dans cet exemple, le sulfure d'étain est dopé au cuivre et au soufre.

Pour une teneur en cuivre de 2,2% et une teneur en soufre de 1,1%, la conductivité moyenne est de 4,02 S/cm, soit une augmentation de cette conductivité comparée à la conductivité moyenne de 2,48 S/cm pour un dopage réalisé uniquement au cuivre (Tableau 2).

En revanche, la diminution dans le même temps du facteur de Seebeck conduit à un facteur de puissance de 229 $\mu$W K$^{-2}$ m$^{-1}$, néanmoins supérieur à 150 $\mu$W K$^{-2}$ m$^{-1}$.

Exemple 6 : Sulfure d'étain dopé au sulfure de cuivre

Dans cet exemple, le sulfure d'étain est dopé au sulfure de cuivre.

Pour une teneur en sulfure de cuivre de 1,1%, la conductivité moyenne est de 3,3 S/cm soit supérieure à la conductivité moyenne de 2,48 S/cm pour un dopage réalisé uniquement au cuivre (Tableau 2).

En revanche, comme pour l'exemple 5, le facteur de Seebeck diminue dans le même temps et le facteur de puissance résultant est ainsi de 175 $\mu$W K$^{-2}$ m$^{-1}$, soit supérieur à 150 $\mu$W K$^{-2}$ m$^{-1}$

Exemple 7 : Sulfure d'étain dopé au sulfure de lithium

Dans cet exemple, le sulfure d'étain est dopé au sulfure de lithium.

Les résultats des performances thermoélectriques du sulfure d'étain dopé au sulfure de lithium sont présentés dans le Tableau 5 ci-dessous pour des pourcentages atomiques en sulfure de lithium variant entre 0,25 et 2.

On constate que pour des teneurs en sulfure de lithium de 0,5 et 1, le facteur de puissance obtenu est supérieur à 150 $\mu$W K$^{-2}$ m$^{-1}$.

Tableau 5

| Teneur en $Li_2S$ (% molaire) | Moyenne du coefficient de Seebeck ($\mu$V/K) | Résistivité moyenne (m$\Omega$ cm) | Conductivité moyenne (S/cm) | Facteur de puissance ($\mu$W K$^{-2}$ m$^{-1}$) |
|---|---|---|---|---|
| 0 | - | 3,30 10$^5$ | 3,03 10$^{-2}$ | - |
| 0,25 | 655 | 406 | 2,46 | 106 |
| 0,5 | 524 | 171 | 5,85 | 161 |
| 1 | 693 | 261 | 3,83 | 184 |
| 2 | 459 | 248 | 4,03 | 84,9 |

Il est à noter dans les Tableaux précédents que pour des teneurs en dopant de 0%, ce qui correspond à du sulfure d'étain pur, la conductivité mesurée est très faible. Par conséquent, si l'on peut admettre que le sulfure d'étain à l'état pur a un comportement de type p, son facteur de puissance associé n'est pas mesurable et il n'est donc pas exploitable comme matériau thermoélectrique.

**Revendications**

1. Matériau thermoélectrique composé de sulfure d'étain incluant la présence d'au moins un dopant produisant un déficit d'électrons, ce qui conduit à réaliser un sulfure d'étain dopé de type p, lequel matériau thermoélectrique présente un facteur de puissance supérieur à 150 $\mu$W K$^{-2}$ m$^{-1}$.

2. Matériau thermoélectrique selon la revendication 1, **caractérisé en ce que** le dopant est un élément présentant un nombre d'oxydation maximum de +1.

3. Matériau thermoélectrique selon l'une quelconque des revendications 1 et 2, **caractérisé en ce que** le sulfure d'étain est dopé avec de l'argent.

4. Matériau selon la revendication 3, **caractérisé en ce que** le pourcentage atomique de l'argent dans le sulfure d'étain est compris entre 0,02 et 5.

5. Matériau selon la revendication 4, **caractérisé en ce que** le pourcentage atomique de l'argent dans le sulfure d'étain est compris entre 0,2 et 3,25.

6. Matériau thermoélectrique selon la revendication 2, **caractérisé en ce que** le sulfure d'étain est dopé avec du cuivre.

7. Matériau thermoélectrique selon la revendication 6, **caractérisé en ce que** le pourcentage atomique de cuivre dans le sulfure d'étain est compris entre 1 et 3.

8. Matériau thermoélectrique selon la revendication 7, **caractérisé en ce que** le pourcentage atomique de cuivre dans le sulfure d'étain est compris entre 2 et 2,5.

9. Matériau thermoélectrique selon la revendication 2, **caractérisé en ce que** le sulfure d'étain est en outre dopé avec du soufre.

10. Matériau thermoélectrique selon la revendication 9, **caractérisé en ce que** le sulfure d'étain est dopé avec de l'argent et du soufre.

11. Matériau thermoélectrique selon la revendication 10, **caractérisé en ce que** le pourcentage atomique d'argent dans le sulfure d'étain est supérieur à 0,5, et **en ce que** le pourcentage atomique de soufre dans le sulfure d'étain est inférieur à 5.

12. Matériau thermoélectrique selon la revendication 11, **caractérisé en ce que** le pourcentage atomique d'argent dans le sulfure d'étain est d'environ 2.

13. Matériau thermoélectrique selon la revendication 9, **caractérisé en ce que** le sulfure d'étain est dopé avec du cuivre et du soufre.

14. Matériau thermoélectrique selon l'une quelconque des revendications 1 et 2, **caractérisé en ce que** le sulfure d'étain est dopé avec un chalcogénure métallique dont le nombre d'oxydation maximum du métal est de +1.

15. Matériau thermoélectrique selon la revendication 14, **caractérisé en ce que** le sulfure d'étain est dopé avec du sulfure d'argent, du sulfure de cuivre ou du sulfure de lithium.

16. Matériau thermoélectrique selon la revendication 14, **caractérisé en ce que** le pourcentage molaire de sulfure d'argent dans le sulfure d'étain est compris entre 0,25 et 1.

17. Procédé de fabrication d'un matériau thermoélectrique selon l'une quelconque des revendications 1 à 16, **caractérisé en ce qu'**il comprend au moins une étape de compactage par frittage d'un mélange broyé de poudres de sulfure d'étain avec au moins un élément dopant.

18. Procédé selon la revendication 17, **caractérisé en ce que** le mélange broyé de poudres est placé dans un moule (2) et est soumis :

    - à une augmentation de température par passage d'un courant dans les poudres au moyen de l'action des deux pistons de compactage (3,4) en appui de contact sur le moule et qui sont reliés à une alimentation électrique, et
    - à une étape de compactage.

**Patentansprüche**

1. Thermoelektrisches Material, zusammengesetzt aus Zinnsulfid, einschließend die Anwesenheit von mindestens einem Dotiermittel, das ein Elektronendefizit erzeugt, was zur Herstellung eines dotierten Zinnsulfids vom Typ p führt, wobei das thermoelektrische Material einen Leistungsfaktor über 150 $\mu$W K$^{-2}$ m$^{-1}$ aufweist.

2. Thermoelektrisches Material nach Anspruch 1, **dadurch gekennzeichnet, dass** das Dotiermittel ein Element ist, das eine maximale Oxidationszahl von +1 aufweist.

3. Thermoelektrisches Material nach einem der Ansprüche 1 und 2, **dadurch gekennzeichnet, dass** das Zinnsulfid mit Silber dotiert ist.

4. Material nach Anspruch 3, **dadurch gekennzeichnet, dass** der Atomprozentsatz des Silbers im Zinnsulfid zwischen 0,02 und 5 inklusive beträgt.

5. Material nach Anspruch 4, **dadurch gekennzeichnet, dass** der Atomprozentsatz des Silbers im Zinnsulfid zwischen 0,2 und 3,25 beträgt.

6. Thermoelektrisches Material nach Anspruch 2, **dadurch gekennzeichnet, dass** das Zinnsulfid mit Kupfer dotiert ist.

7. Thermoelektrisches Material nach Anspruch 6, **dadurch gekennzeichnet, dass** der Atomprozentsatz des Kupfers im Zinnsulfid zwischen 1 und 3 beträgt.

8. Thermoelektrisches Material nach Anspruch 7, **dadurch gekennzeichnet, dass** der Atomprozentsatz des Kupfers im Zinnsulfid zwischen 2 und 2,5 beträgt.

9. Thermoelektrisches Material nach Anspruch 2, **dadurch gekennzeichnet, dass** das Zinnsulfid ferner mit Schwefel dotiert ist.

10. Thermoelektrisches Material nach Anspruch 9, **dadurch gekennzeichnet, dass** das Zinnsulfid mit Silber und Schwefel dotiert ist.

11. Thermoelektrisches Material nach Anspruch 10, **dadurch gekennzeichnet, dass** der Atomprozentsatz von Silber im Zinnsulfid größer als 0,5 ist und dass der Atomprozentsatz von Schwefel im Zinnsulfid kleiner als 5 ist.

12. Thermoelektrisches Material nach Anspruch 11, **dadurch gekennzeichnet, dass** der Atomprozentsatz von Silber im Zinnsulfid zirka 2 beträgt.

13. Thermoelektrisches Material nach Anspruch 9, **dadurch gekennzeichnet, dass** das Zinnsulfid mit Kupfer und mit Schwefel dotiert ist.

14. Thermoelektrisches Material nach einem der Ansprüche 1 und 2, **dadurch gekennzeichnet, dass** das Zinnsulfid mit einem metallischen Chalcogenid dotiert ist, dessen maximale Oxidationszahl des Metalls +1 ist.

15. Thermoelektrisches Material nach Anspruch 14, **dadurch gekennzeichnet, dass** das Zinnsulfid mit Silbersulfid, Kupfersulfid oder Lithiumsulfid dotiert ist.

16. Thermoelektrisches Material nach Anspruch 14, **dadurch gekennzeichnet, dass** der molare Prozentsatz von Silbersulfid im Zinnsulfid zwischen 0,25 und 1 inklusive beträgt.

17. Verfahren zur Herstellung eines thermoelektrischen Materials nach einem der Ansprüche 1 bis 16, **dadurch gekennzeichnet, dass** es mindestens einen Kompaktierungsschritt durch Sintern eines zerkleinerten Gemischs von Zinnsulfidpulvern mit mindestens einem dotierenden Element umfasst.

18. Verfahren nach Anspruch 17, **dadurch gekennzeichnet, dass** das zerkleinerte Pulvergemisch in einer Form (2) platziert wird und unterzogen:

   - einer Temperaturerhöhung durch Durchgang eines Stroms in den Pulvern mittels der Wirkung der zwei Kompaktierungskolben (3, 4) in Stützkontakt auf der Form, die mit einer Stromversorgung verbunden sind, und
   - einem Kompaktierungsschritt.

**Claims**

1. Thermoelectric material composed of tin sulfide including the presence of at least one dopant producing electron deficiency, leading to the obtaining of a p-type doped tin sulfide, said thermoelectric material having a power factor higher than 150 $\mu$W K$^{-2}$ m$^{-1}$.

2. The thermoelectric material according to claim 1, **characterized in that** the dopant is an element having a maximum oxidation state of +1.

3. The thermoelectric material according to any of claims 1 and 2, **characterized in that** the tin sulfide is doped with silver.

4. The material according to claim 3, **characterized in that** the atomic percentage of silver in the tin sulfide is between 0.02 and 5.

5. The material according to claim 4, **characterized in that** the atomic percentage of silver in the tin sulfide is between 0.2 and 3.25.

6. The thermoelectric material according to claim 2, **characterized in that** the tin sulfide is doped with copper.

7. The thermoelectric material according to claim 6, **characterized in that** the atomic percentage of copper in the tin sulfide is between 1 and 3.

8. The thermoelectric material according to claim 7, **characterized in that** the atomic percentage of copper in the tin sulfide is between 2 and 2.5.

9. The thermoelectric material according to claim 2, **characterized in that** the tin sulfide is also doped with sulfur.

10. The thermoelectric material according to claim 9, **characterized in that** the tin sulfide is doped with silver and with sulfur.

11. The thermoelectric material according to claim 10, **characterized in that** the atomic percentage of silver in the tin sulfide is higher than 0.5, and **in that** the atomic percentage of sulfur in the tin sulfide is lower than 5.

12. The thermoelectric material according to claim 11, **characterized in that** the atomic percentage of silver in the tin sulfide is about 2.

13. The thermoelectric material according to claim 9, **characterized in that** the tin sulfide is doped with copper and with sulfur.

14. The thermoelectric material according to any of claims 1 and 2, **characterized in that** the tin sulfide is doped with a metal chalcogenide, the maximum oxidation state of the metal being +1.

15. The thermoelectric material according to claim 14, **characterized in that** the tin sulfide is doped with silver sulfide, copper sulfide or lithium sulfide.

16. The thermoelectric material according to claim 14, **characterized in that** the mole percentage of silver sulfide in the tin sulfide is between 0.25 and 1.

17. Method for fabricating a thermoelectric material according to any of claims 1 to 16, **characterized in that** it comprises at least one compacting step by sintering a ground mixture of tin sulfide powders with at least one doping element.

18. The method according to claim 17, **characterized in that** the ground mixture of powders is placed in a mould (2) and is subjected to:

    - an increase in temperature by passing a current through the powders by means of the action of two compacting pistons (3,4) pressed in contact against the mould and connected to a power supply; and
    - a compacting step.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DAVID PARKER et al.** First principles investigations of the thermoelectric behavior of tin sulfide. *JOURNAL OF APPLIED PHYSICS,* 01 Janvier 2010, vol. 108 (8), ISSN 0021-8979, 083712
- **M. DEVIKA et al.** Low Resistive Micrometer-Thick SnS:Ag Films for Optoelectronic Applications. *JOURNAL OF THE ELECTROCHEMICAL SOCIETY,* 01 Janvier 2006, vol. 153 (8), ISSN 0013-4651, G727
- **ARTIT WANGPERAWONG et al.** Vapor transport déposition and epitaxy of orthorhombic SnS on glass and NaCl substrates. *APPLIED PHYSICS LETTERS,* 01 Janvier 2013, vol. 103 (5), ISSN 0003-6951
- Temperature dependence of the electrical conductivity, Hall effect and thermoelectric power of SnS single crystals. **NASSARY et al.** JOURNAL OF ALLOYS AND COMPOUNDS. ELSEVIER SEQUOIA, 02 Août 2005, vol. 398, 21-25